# EUROPEAN PATENT APPLICATION

(11) **EP 4 496 008 A1**
(43) Date of publication of application: **22.01.2025**
(21) Application number: 23186643.5
(22) Date of filing: 20.07.2023
(51) Int. Cl.: H01L 29/778, H01L 29/20

(54) **A III-NITRIDE SEMICONDUCTOR DEVICE WITH IMPROVED BACK BARRIER DESIGN**

(71) Applicant: Imec VZW, 3001 Leuven (BE)
(72) Inventor: YU, Hao, 3001 Leuven (BE); PARVAIS, Bertrand, 1457 Nil-Saint-Vincent (BE)
(74) Representative: Patent Department IMEC

(57) **Abstract**

The transistor is a III-nitride device in the sense that it comprises a channel layer (4) and a barrier layer (5) on the channel layer, configured so that a 2-dimensional charge gas (6) can be formed near the interface between the two layers. The channel layer lies directly on a buffer layer (10). A top layer (10c) of the buffer layer is a back barrier layer comprising dopant elements. The back barrier layer lies directly on an intrinsic III-nitride layer (10b). The thickness of the back barrier layer (10c) and the dopant concentration in said back barrier layer are such that when the transistor is operational, essentially all the dopant elements in the back barrier layer are ionized, thereby essentially preventing charge trapping into this back barrier layer and charge hopping within this back barrier layer. The thickness of the intrinsic III-nitride layer (10b) is such that when the transistor is operational, said intrinsic III-nitride layer minimizes charge movement from the back barrier layer to the base buffer layer, meaning that the intrinsic III-nitride layer maintains said charge movement at a sufficiently low level so as not to compromise normal operation of the transistor.

## Description

### Field of the Invention

The present invention is related to III-nitride based semiconductor transistors, such as GaN-based High Electron Mobility Transistors (HEMT) or GaN-based metal-oxide-semiconductor field effect transistors (MOSFET).

### State of the art.

III-nitride transistors are based on the formation of high mobility charge carriers near the interface between a channel layer and a barrier layer formed of different and lattice-mismatched III-nitride materials having specific intrinsic characteristics in terms of their crystal structure. A well-known combination is a GaN channel layer with an AlGaN barrier layer on top. Because of the lattice mismatch between the layers and the effects of the spontaneous and piezo-electric polarizations occurring within the crystal structures of the materials, a so-called 2DEG (2-dimensional electron gas) is formed in the channel layer, at the interface between the channel layer and the barrier layer, exhibiting high electron mobility in the plane of the 2DEG.

The confinement of the electrons in the plane of the 2DEG can be realized or enhanced by the inclusion of a back barrier directly underneath the channel layer. The back barrier is in fact part of a thick buffer layer aimed at compensating the lattice mismatch between the channel layer and the substrate onto which the transistor is built. In the case of a GaN/AlGaN device, the back barrier may be a GaN layer comprising a high concentration of dopant elements acting as electron acceptors. Typically applied acceptor type dopants include carbon, beryllium or magnesium. These elements become negatively ionized by accepting electrons from the 2DEG in the channel layer, thereby forming negative charge at the interface between the back barrier layer and the channel layer, which acts to confine the channel electrons to the plane of the 2DEG. Acceptor type dopant elements may also be included deeper in the buffer layer, in order to form charge traps and thereby increase the breakdown voltage of the transistor.

In an AlGaN/GaN device, a typically applied back barrier is a relatively thick carbon doped GaN layer directly underneath the GaN channel layer. However, non-ionized acceptors in the back barrier and deeper layers of the buffer are likely to trap electrons from the 2DEG, which further depletes the 2DEG in the channel and thereby degrades the on-state resistance of the transistor. In particular, physical processes of charge trapping into the back barrier and charge hopping within the back barrier are likely to take place under the influence of an external electric field, for example when a high source-drain voltage is applied in the case of a HEMT. Charge trapping refers to the capturing of electrons from the transistor channel by non-occupied acceptors in the back barrier. Charge hopping refers to the movement of electrons from carbon ions to non-occupied acceptors in the back barrier, leaving non-occupied acceptors near the interface with the channel layer, which are then likely to further attract electrons from the 2DEG.

### Summary of the invention

The invention aims to provide a solution to the problems highlighted above. This aim is achieved by an integrated transistor in accordance with the appended claims. The term 'integrated' refers to the fact that the transistor is incorporated in a semiconductor component such as an integrated circuit chip. The transistor is a III-nitride device in the sense that it comprises a channel layer and a barrier layer on the channel layer, configured so that a 2-dimensional charge gas can be formed near the interface between the two layers. The channel layer lies directly on a buffer layer. A top layer of the buffer layer is a back barrier layer comprising dopant elements. The back barrier layer lies directly on an intrinsic III-nitride layer. The thickness of the back barrier layer and the dopant concentration in said back barrier layer are such that when the transistor is operational, essentially all the dopant elements in the back barrier layer are ionized, thereby essentially preventing charge trapping into this back barrier layer and charge hopping within this back barrier layer. The thickness of the intrinsic III-nitride layer is such that when the transistor is operational, said intrinsic III-nitride layer minimizes charge movement from the back barrier layer to the base buffer layer, meaning that the intrinsic III-nitride layer maintains said charge movement at a sufficiently low level so as not to compromise normal operation of the transistor.

The invention is in particular related to an integrated III-nitride semiconductor transistor comprising a substrate, a buffer layer on the substrate, a channel layer on the buffer layer, a barrier layer on the channel layer, and source drain and gate terminals, wherein a 2-dimensional charge gas may be formed in the channel layer, near the interface with the barrier layer, depending on voltages applied to the source, drain and gate electrodes,
characterized in that the buffer layer comprises :
   - a base buffer layer directly on the substrate,
   - an intrinsic III-nitride layer directly on the base buffer layer,
   - a back barrier layer directly on the intrinsic III-nitride layer, the back barrier layer being a III-nitride layer comprising dopant elements which act as electron acceptors or electron donors, depending on the charge type of the 2-dimensional charge gas, and
wherein the thickness of the back barrier layer and the dopant concentration in said back barrier layer are such that when the transistor is operational, essentially all the dopant elements in the back barrier layer are ionized, and wherein the thickness of the intrinsic III-nitride layer is such that when the transistor is operational, said intrinsic III-nitride layer minimizes charge movement from the back barrier layer to the base buffer layer.

According to an embodiment, the channel layer is an intrinsic GaN layer, the barrier layer is an AlGaN layer, the back barrier layer is a doped GaN layer and the intrinsic III-nitride layer is also an intrinsic GaN layer.

In the latter case, the thickness of the back barrier layer may be between 1 nm and 30 nm and the dopant elements may carbon dopants. The net dopant concentration of said carbon dopants in the back barrier layer may be between 5e17 cm⁻³ and 5e19 cm⁻³.

According to an embodiment, the dopant elements in the back barrier layer comprise one or more of the following : C, Zn, Fe, Mg.

According to an embodiment, the transistor of the invention is a HEMT or a MOSFET.

### Brief description of the figures

Figure 1 shows a III-nitride transistor in accordance with the prior art.
Figure 2 shows a III-nitride transistor in accordance with an embodiment of the invention.
Figures 3a to 3c illustrate the band diagram for three different back barrier configurations.

### Detailed description of the invention

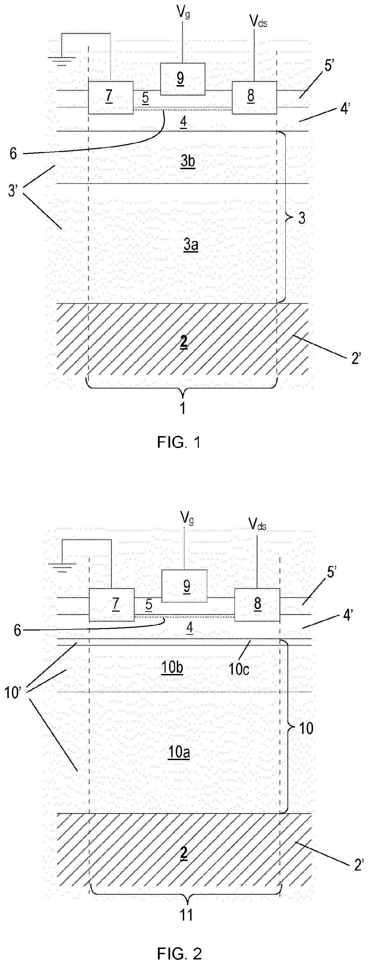

A prior art transistor will first be described in more detail, followed by a description of a device according to the invention. Figure 1 illustrates a typical structure of an integrated AlGaN/GaN HEMT 1 as presently known in the art. The image shows a small section of a larger component such as an integrated circuit chip comprising multiple transistors and possibly other semiconductor devices interconnected according to a given layout. In the present context, the transistor 1 is defined as a section of the larger component, said section being situated between the dotted lines shown in Figure 1.

In that sense, the transistor 1 firstly comprises a substrate portion 2 that is part of a larger substrate 2'. The substrate 2' may be any substrate suitable for producing thereon a III-nitride semiconductor device. Well known examples thereof include silicon, silicon carbide or sapphire substrates. The transistor 1 further comprises a buffer layer 3 on the substrate portion 2, which is again part of a larger buffer layer 3'. The buffer layer comprises a base buffer layer 3a which may be structured according to any known buffer design. The main purpose of this base buffer layer 3a is to alleviate the effects of the mismatch between the lattice constants of the substrate 2' and the active layers of the transistor. The base buffer layer 3a may for example comprise an AlN nucleation layer grown on a silicon substrate 2', and a stack of AlGaN layers with stepwise decreasing Al-concentration. The base buffer layer 3a may also comprise intentionally added charge trapping defects intended to reduce the leakage current and thereby increase the breakdown voltage of the transistor.

The active layers comprise the channel layer 4 (part of a larger layer 4') which is an intrinsic GaN layer, and the barrier layer 5 (part of a larger layer 5'). An intrinsic GaN layer is an epitaxially grown GaN layer that does not comprise intentionally added dopant elements. It is therefore a crystalline GaN layer having the typical crystal structure of crystalline GaN and comprising no dopant elements other than impurities unavoidably included in the structure during the epitaxial growth process, such as oxygen molecules, which do not influence the functionality of the transistor.

The barrier layer 5 is an AlGaN layer of a composition and thickness chosen so that a 2DEG (2-dimensional electron gas) 6 may be formed in the channel layer 4, near the interface between the channel layer 4 and the barrier layer 5. Source and drain electrodes 7 and 8 are in electrical contact with the 2DEG 6, and a gate electrode 9 is produced between the source and drain. When the transistor is operational, the source electrode 7 is coupled to a ground or any other suitable reference voltage as illustrated in the drawing. The gate electrode 9 is coupled to a gate voltage V_{g}, configured to modulate the 2DEG 6, while the drain electrode 8 is coupled to a source-drain voltage V_{ds} which may be a high voltage of 20 V or higher. These connections are realized through a multilayer back end of line type interconnect structure (not shown) formed on top of the source, drain and gate electrodes, as known in the art.

In general terms within the present context, a III-nitride transistor is said to be 'operational' when the source, drain and gate terminals are coupled to suitable voltages for the transistor to either conduct current or block current, i.e. the 2DEG is not necessarily present when the device is 'operational'.

The buffer layer 3 further comprises a back barrier layer 3b directly on the base buffer layer 3a and directly underneath the channel layer 4. The back barrier layer 3b may be a carbon-doped GaN layer (hereafter abbreviated as `C-GaN') as referred to in the introduction. The majority of carbon dopants function as electron acceptors, and the resulting negatively ionized carbon ions act to confine the 2DEG. However, besides the ionized carbon accepters, the back barrier 3b also contains a large quantity of non-ionized acceptors that may further induce trapping and degrade the transistor conductance.

The thickness of the different layers can vary within a certain range depending for example on the applied voltages and the channel length. For example the channel layer 4 may be in the order of 20nm to 200nm thick, with the barrier layer 5 generally being somewhat less thick than the channel layer. The base buffer layer 3a may be several hundreds of nanometers thick, depending on the structure of this layer and on the required power characteristics of the transistor. The C-GaN back barrier layer 3b in GaN/AlGaN HEMT devices as presently known in the art is thick to limit vertical leakage and provide high vertical breakdown voltage.

Figure 2 illustrates a GaN/AlGaN HEMT transistor 11 according to an embodiment of the invention, described hereafter as an example only. Other III-nitride materials can be applied as will be explained further in this text.

The substrate portion 2 and the channel and barrier layers 4,5 can be the same as in the prior art in terms of materials and layer thicknesses. The difference with the prior art lies in the way in which the back barrier function is realized. The buffer layer 10 again comprises a base buffer layer 10a, which may be the same as the base buffer layer 3a in the prior art device. On top of the base buffer layer 10a, two layers are now present: an intrinsic GaN layer 10b and a back barrier layer in the form of a thin carbon-doped GaN layer 10c. The thickness of the C-GaN layer 10c and the dopant concentration of this layer are such that essentially all the carbon acceptors in this layer are ionized when the transistor is operational (as defined above). In practice, this means that the back barrier layer 10c is significantly thinner than the other buffer layers including 10a and 10b. The thickness of the thin C-GaN layer 10c may for example be between 1 nm and 5 nm, depending on the carbon concentration and the thickness of the channel layer.

Directly underneath the thin back barrier layer 10c and directly on top of the base buffer layer 10a is an intrinsic GaN layer 10b of high thickness compared to the thin back barrier 10c. The function of the intrinsic layer 10b is to provide an essentially defect-free layer between the thin back barrier layer 10c and the base buffer layer 10a, of sufficient thickness to minimize the movement of negative charge from the back barrier layer 10c to the base buffer layer 10a. Such movement may be the consequence of negative charge being captured by charge traps in said base buffer layer 10a. The term 'minimize' should be understood in the present context as : 'maintain at a sufficiently low level so as not to compromise normal operation of the transistor'. The thickness of the intrinsic GaN layer 10b may depend on the source-drain voltage. In a HEMT device, this layer may for example have a thickness of 300nm or more.

The fact that the thin back barrier layer 10c is fully ionized prevents the phenomenon of additional charge trapping into this back barrier layer and prevents charge hopping within this thin back barrier layer.

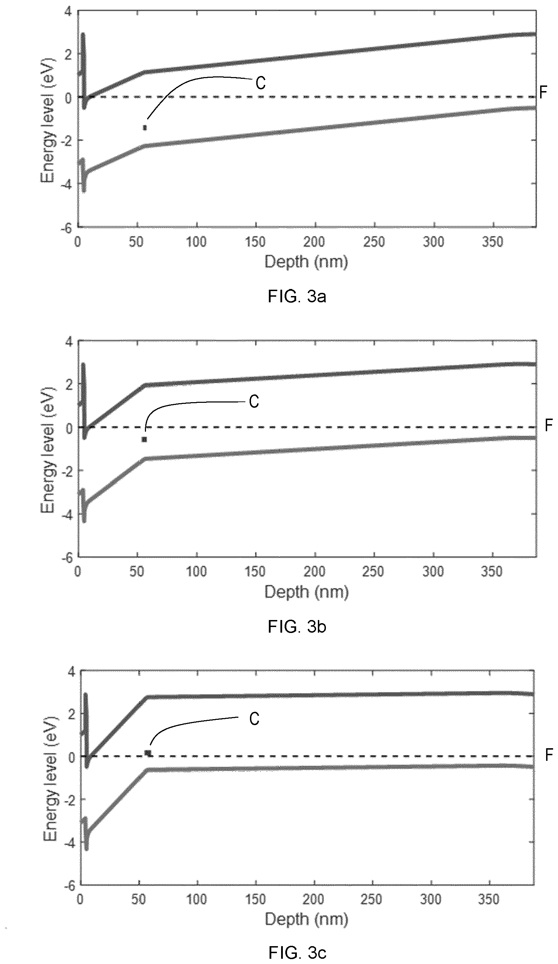

In order to obtain full ionization, careful tuning of the back barrier thickness is required as a function of the carbon concentration and the channel layer thickness. This is illustrated in Figures 3a to 3c, which show band diagrams for three different configurations of layer stacks on top of the base buffer portion 10a. In each of these configurations, the thick intrinsic GaN layer 10b has a thickness of 300 nm, the GaN channel layer 4 is 50 nm thick and the AlGaN barrier layer is 4 nm thick. The net C acceptor concentration in the thin C-GaN barrier layer 10c is 1E19 cm⁻³. The net C acceptor concentration is the difference between the concentration of C-atoms replacing N atoms in the GaN lattice and the concentration of C-atoms replacing Ga atoms. The difference between the three cases lies in the thickness of the C-GaN back barrier layer: 1nm (Figure 3a), 2nm (Figure 3b), 3nm (Figure 3c).

The images illustrate that full ionization is obtained for the C-GaN layers of 1 and 2 nm, but that the 3 nm C-GaN layer exhibits only partial ionization. This is derivable from the fact that in the first two cases, the Fermi level F is significantly higher than the carbon acceptor trapping level, indicated by a point marked 'C' for each case in the drawings.

When the C-concentration is lower, the thickness of the C-GaN barrier can be higher before full ionization is lost.

Also, the thickness of the GaN channel plays a part : the higher the channel thickness, the lower the C-GaN thickness of the back barrier required for full ionization for a given C-concentration.

Based on these findings, it is clear that the optimum in terms of full ionization depends on a number of parameters. According to an embodiment applicable to an AlGaN/GaN HEMT transistor, the thickness of the C-GaN back barrier layer is between 1 and 30 nm and the net C acceptor concentration is between 5e17 and 5e19 cm⁻³. Optimum values of both parameters are applicable as a function of the channel thickness.

However, preferred values or ranges of these parameters may be different for transistor types other than a HEMT, or for III-nitride transistors formed of other III-N materials, and/or comprising dopant elements in the thin back barrier other than C or a combination of different dopant elements.

As stated, other suitable III-nitride materials may be used in a transistor according to the invention. Any known combination of materials suitable for creating a 2-dimensional high-mobility charge layer (i.e. a 2DEG or a 2DHG - 2-dimensional hole gas) may be used. When a 2DHG is formed in the channel layer, the thin back barrier layer comprises electron donors at a net concentration configured so that essentially all the donor elements in the back barrier layer are positively ionized when the transistor is operational.

According to embodiments of the invention, multiple different dopant elements can be included in the thin back barrier layer. For example in the case an GaN/AlGaN device, other electron acceptors can be included in the thin back barrier layer in addition to or instead of C, such as one or more of the following : Be, Zn, Fe, Mg.

Producing the thin back barrier layer can be done by known techniques. For example, producing a thin C-GaN layer of 1 to 5 nm on an intrinsic GaN layer can be done by MOCVD (metal organic chemical vapour deposition), wherein the precursors for growing GaN are supplied to an MOCVD reactor together with a supply of C, and wherein the various process parameters are configured to obtain a pre-defined carbon concentration in a GaN layer of predefined thickness.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. An integrated III-nitride semiconductor transistor (11) comprising a substrate (2), a buffer layer (10) on the substrate, a channel layer (4) on the buffer layer, a barrier layer (5) on the channel layer, and source drain and gate terminals (7,8,9), wherein a 2-dimensional charge gas (6) may be formed in the channel layer, near the interface with the barrier layer, depending on voltages applied to the source, drain and gate electrodes,
**characterized in that** the buffer layer (10) comprises :
- a base buffer layer (10a) directly on the substrate (2),
- an intrinsic III-nitride layer (10b) directly on the base buffer layer (10a),
- a back barrier layer (10c) directly on the intrinsic III-nitride layer (10b), the back barrier layer being a III-nitride layer comprising dopant elements which act as electron acceptors or electron donors, depending on the charge type of the 2-dimensional charge gas, and
wherein the thickness of the back barrier layer (10c) and the dopant concentration in said back barrier layer (10c) are such that when the transistor is operational, essentially all the dopant elements in the back barrier layer are ionized, and wherein the thickness of the intrinsic III-nitride layer (10b) is such that when the transistor is operational, said intrinsic III-nitride layer (10b) minimizes charge movement from the back barrier layer (10c) to the base buffer layer (10a).

2. The transistor according to claim 1, wherein the channel layer (4) is an intrinsic GaN layer, the barrier layer (5) is an AlGaN layer, the back barrier layer (10c) is a doped GaN layer and the intrinsic III-nitride layer (10b) is also an intrinsic GaN layer.

3. The transistor according to claim 2, wherein the thickness of the back barrier layer (10c) is between 1 nm and 30 nm.

4. The transistor according to claim 2 or 3, wherein the dopant elements are carbon dopants.

5. The transistor according to claim 4, wherein the net dopant concentration in the back barrier layer (10c) is between 5e17 cm⁻³ and 5e19 cm⁻³.

6. The transistor according to any one of the preceding claims, wherein the dopant elements in the back barrier layer (10c) comprise one or more of the following : C, Zn, Fe, Mg.

7. The transistor according to any one of the preceding claims, wherein the transistor is a HEMT or a MOSFET.
